# EUROPEAN PATENT APPLICATION

(11) **EP 4 826 392 A1**
(43) Date of publication of application: **21.10.2026**
(21) Application number: 25170754.3
(22) Date of filing: 15.04.2025
(51) Int. Cl.: G01R 1/04, G01R 15/18, G01R 35/02

(54) **SYSTEM AND METHOD FOR MEASURING ELECTRICAL VALUE IN LOW-VOLTAGE NETWORK**

(71) Applicant: TQ-Systems GmbH, 82229 Seefeld (DE)
(72) Inventor: Preuss, Paul, 82229 Seefeld (DE); Tauch, Tim, 82229 Seefeld (DE); Köthe, Daniel, 82229 Seefeld (DE)
(74) Representative: WBH Wachenhausen Patentanwälte PartG mbB

(57) **Abstract**

The present invention relates to a system for measuring at least one electrical value in a low-voltage network, wherein the system comprises at least one current transformer (14) and a packaging (200) in which the current transformer (14) is provided, wherein the packaging (200) is configured to allow access to the current transformer (14) for determining a sensing error while the current transformer (14) remains in the packaging (200). The invention also relates to a method of providing a system for measuring at least one electrical value to a user.

## Description

### Technical Field

The present disclosure relates to a system for measuring at least one electrical value. The present disclosure also relates to a packaging for a current transformer and a method of providing a system for measuring at least one electrical value to a user.

### Technical Background

Systems for measuring at least one electrical value in a power line or an electrical network are known in the art. Such systems may use a current transformer. When connected to the power line, the current transformer may provide a current that is reduced in comparison to a current in the power line but proportional thereto. The reduced current may therefore be easier to handle by a measuring instrument and/or protective relays. However, the reduced current provided by the current transformer may not be fully proportional to the current in power lines. A control using electrical values measured with the reduced current provided by the current transformer may thus be imprecise. Current transformers are available in different classes of precision, wherein a higher class provides a reduced current that is more proportional to the current in the power line. To improve the precision of the measurement, a higher class for the current transformer may thus be chosen. However, a higher class may be disproportionally more expensive. In addition, a current transformer with a high class may be large and/or heavy. For example, to have a low error in the phase shift, a core of the current transformer may need to be larger than required to provide a sufficient reduction in current for the measuring instrument. Alternatively or additionally, a high-quality core material needs to be used. Further, a manufacturer needs to check a precision of the current transformer and provide sufficient documentation.

### Description of the Invention

A first aspect of the invention relates to a system for measuring at least one electrical value in a low-voltage network, for example in one or several power lines of the network.

A low-voltage network may be an electrical network, for example for supplying electrical power within a home, a small industrial installation or a commercial operation. A voltage in the low-voltage network may be 230 V, 400 V, 500 V or 690 V. The system may be configured to measure the at least one electrical value in alternating and/or direct current. The system may also be configured for measuring the at least one electrical value in three-phase current, wherein each phase may be provided by one power line. The system may be configured to measure several electrical values. Examples for electrical values to be measured may be an amperage, a voltage, a power output, performance factors and a frequency.

The system comprises at least one current transformer. A current transformer may be a type of transformer that reduces a current at a primary interface to be provided at a secondary interface. The reduced current at the secondary interface may be proportional to the current at the primary interface. The current transformer may have a primary winding, a core and a secondary winding. The alternating current in the primary winding produces an alternating magnetic field in the core, which then induces an alternating current in the secondary winding. The primary winding may be formed by the power line. For example, the current transformer may have a steel ring core with secondary copper winding wound around it. The primary winding may be the power line and configured as a straight section arranged through the center of the core. The current in the primary winding may thus induce a reduced current in the secondary winding. The current transformer may be a current-sensing unit which creates a sensor signal depending on a state of the power line to which the current transformer is connected. One current transformer may be provided per power line to be measured. A current input in the current transformer may be the current in the primary winding or power line. A current output of the current transformer may be the reduced current in the secondary winding or the output to the measuring unit.

The current transformer may be pre-assembled, such as with required connection parts. For example, the current transformer may comprise a plug for connecting to a measuring unit and/or a power line. The current transformer may be configured as a clamp-on current transformer or as a plug-in current transformer. A plug-in current transformer may be included in an integrated current transformer unit configured for more than one power line, such as three power lines. Such a current transformer unit may, for example, comprise three current transformers. A plug-in current transformer unit may comprise multiple, such as two, three, four or six, plug-in current transformers in a common housing.

The system comprises a packaging in which the current transformer is provided. The packaging may be a packaging for the current transformer. For each current transformer, a corresponding packaging may be provided. The packaging may be a carton or plastic box. The packaging may comprise an outer shell and/or an inner holder. The outer shell may provide protection. The inner holder may hold the current transformer in place, for example inside the outer shell. The inner holder may be formed to correspond to the shape of the current transformer and/or outer shell. The inner holder may be arranged in the outer shell. The outer shell may have a basic shape of a cube. The packaging may be sealed when the system is provided in a set. The packaging may be adjustable between a closed state and an open state, for example by closing and opening a lid of the outer shell. In the closed state, the current transformer cannot be taken out of the packaging. In the open state, the current transformer can be taken out of the packaging.

The packaging is configured to allow access to the current transformer for determining a sensing error, e.g. with a measurement device, while the current transformer remains in the packaging. This may allow to adjust the sensing error compensation in a measuring unit without the need for opening the packaging, extraction of the current transformer and/or repacking of the current transformer. For example, the packaging may be configured to allow access to the current transformer for determining a sensing error while the packaging remains in a closed state. For example, the packaging may allow connection of the current transformer to a power line and/or a measuring device without removal from the packaging for adjustment of the compensation in the measuring unit. The measuring device may be configured to determine the sensing error of the current transformer. This may allow calibrating the compensation for the sensing error and to appropriately adjust the measuring unit. The current transformer may comprise all necessary connections, such as a plug for connecting to the measuring device and/or a connection ready for attachment to the power line when arranged in the packaging.

The first aspect of the invention allows for determination of the sensing error of the current transformer without removal of the current transformer from the packaging. For example, a measuring device for determining the sensing error of the current transformer may be connected to the current transformer while the current transformer remains in the packaging.

In an embodiment, the packaging comprises an access opening for connection of a power line to the current transformer in the packaging when the packaging is in a closed state. The opening may be configured as a through hole through a wall and/or from one side to an opposite side of the packaging. For example, in the case of a clamp-on current transformer, the packaging may have a through hole that allows inserting a power line through the core of the current transformer and/or through the packaging. The core of the current transformer in the packaging may be arranged around the through hole.

Alternatively or additionally, the packaging comprises an access opening for connection of a measuring device to the current transformer in the packaging. The measuring device may be a dedicated device for calibration of the sensing error compensation. The access opening for connecting the measuring device may be a through hole in an outer wall in which a plug of the current transformer is immovably arranged with a plugging surface facing towards the through hole. Any access opening may be present in the outer shell and/or inner holder.

In an embodiment, the packaging comprises an outer shell and an inner holder for holding the current transformer in place inside of the outer shell, preferably for fixing the position of the current transformer relatively to at least one of the access openings. The inner holder may be formed by one or several parts, which may be connected or provided separately from each other. In one embodiment, the inner hold fixes the position of the current transformer relatively to both access openings to ensure that both access openings are coaxially aligned with the current transformer itself and/or a plug of the current transformer, respectively.

In an embodiment, the current transformer comprises a plug for connection to a measuring device, e.g. the measuring unit of the present disclosure. The plug is preferably accessible for connection of the measurement device when the current transformer is provided in the closed packaging. Therefore, the plug of the current transformer may be accessible when the current transformer is provided in the closed packaging for determining a sensing error of the current transformer with a measurement device. The plug may be installed and accessible when the current transformer is provided to the system manufacturer and/or end customer.

In an embodiment, the system further comprises a measuring unit, wherein the measuring unit is configured for compensating the sensing error of the current transformer. The sensing error of the current transformer may have been determined via the measurement device with the current transformer in the closed packaging as described above. The measuring unit may be connected to the secondary winding of the current transformer. The measuring unit may be configured to measure any required electrical value in the secondary winding. The measuring unit may be configured to provide the measured electrical values to a further component, such as a control device. The measuring unit may measure the amperage and/or voltage provided by the current transformer. The measuring unit may be configured to determine the electrical value based on the sensor signal of the current transformer. The measuring unit may be configured to transmit any determined electrical value to another device, such as a home energy management system.

The system may be configured as a set. For example, the set may contain the measuring unit and one or several current transformers. The parts of the set may not be connected to each other. The set may require connection of its part to render it functional for measurements. For example, the current transformer and the measuring unit may not be connected to each other. For example, the current transformer and the measuring unit may be provided in separate packagings. This allows a high flexibility regarding a number of current transformers. For example, the current transformers may be purchased by the manufacturer from a third party and may be provided to the manufacturer of the set in a packaging, such as a carton box. The manufacturer of the set may leave the current transformers in their original packaging when providing them to their customers. This may reduce expenses for packaging and/or shipping. The system may comprise three or six current transformers to measure electrical values in a three-phase current.

The measuring unit may be configured for compensating a sensing error of the current transformer. The sensing error may be an error in the proportionality between the current output for the measuring device and the current input. The compensation may reduce an error in the measurement of one or several electrical values, for example below the error in proportionality in the current transformer. The measuring unit thus allows the use of a low-cost current transformer while achieving a measurement precision similar to the use of a high precision current transformer with a measuring unit not having such a compensation. This may result in a precise, compact and low-cost system for measuring the at least one electrical value.

The compensation in the measuring unit may be adjustable. For example, the sensing error of the current transformer may be determined before assembling and/or compiling the system or set. An individual sensing error of each current transformer in the system may be determined. The compensation in the measuring unit may be set accordingly. The compensation may only be manufacturer adjustable or also adjustable by an end-user.

If the system comprises several current transformers, they might be labeled so that each current transformer is connected to a specific interface in the measuring system. Alternatively or additionally, a connection of the different current transformers might only fit a certain, dedicated interface port at the measuring unit. This may ensure compensation is allocated to the correct current transformer. For example, each current transformer of the system can only be connected to a specific socket matching its individual plug. The compensation for each interface might then be set according to the individual sensing error of each current transformer. Alternatively, the system may be configured for identification of current transformers and the compensation be defined for the identified current transformers. For example, the current transformers may transmit an ID to the measuring unit. For each ID, an appropriate compensation may be set in the measuring unit. For example, the compensation may be an offset value, a table for transforming values and/or a curve for compensating sensor signal errors. The compensation may consider a characteristic line of current transformation in the current transformer whose sensing error is to be compensated.

In an embodiment, the measuring unit is configured for an adjustable gain and/or phase shift compensation. For example, the sensing error may comprise a gain and/or a phase shift. Such compensation may be provided for each input channel or current transformer. The gain may relate to an amplitude of a signal.

In an embodiment, the measuring unit comprises a first circuit board, a second circuit board, a measuring component and a data transmission device. A circuit board may comprise a substrate and electrical lines etched therein. A circuit board may be configured as a PCB (printed circuit board). Electrical components, such as microprocessors and capacitators, may be connected to the circuit board. The measuring component may be configured to determine the electrical values from signals or the reduced current received from the current transformer. The measuring component may be configured as a meter, e.g. a smart meter, in particular a metering-integrated circuit or metering-IC. The data transmission device may be configured to send the determined electrical values to other devices, such as a control device. The data transmission device may comprise interfaces, such as for example an Ethernet, RS-485, WIFI and/or EEbus data transmission. The data transmission device may be configured for encryption of transmitted data. The measuring device may be formed on the first circuit board. The data transmission device may be formed on the second circuit board. This allows a modularity in the internal configuration and thus to easily adapt the measuring unit to different purposes and/or standards without the need to redesign all circuit boards. A connection for a power supply may be formed on the first circuit board. The two circuit boards allow for easy surge protection of other devices connected to the data transmission device. For example, the two circuit boards may be galvanically isolated from each other.

The two circuit boards may be connected to each other by a board connector, such as a circuit board plug connector. The board connector may provide the galvanic insulation. The two circuit boards can be connected via the circuit board plug connector, for example for data transmission. The circuit board plug connector can, for example, be designed as an eight-pole connector. The circuit board plug connector can have a socket and a plug. The socket can be designed to receive the plug. The socket can have one or more recesses. The socket is formed, for example, on the second printed circuit board. The plug can be designed to be inserted into the socket. The plug can have one or more protruding sections, such as stiff copper conductors. The plug is formed, for example, on the first circuit board. The plug can, for example, be formed on the one of the two circuit boards that is mounted first. The protruding part of the plug can then be easier to assemble with the socket when the two circuit boards are mounted, for example by simply plugging the socket in. The protruding part can help with alignment.

In an embodiment, the first circuit board is arranged spaced apart to the second circuit board, for example in an interior space of a housing of the measuring unit. Such a configuration may facilitate galvanic isolation and/or a compact design. For example, the first and second circuit boards are arranged above and/or parallel to each other. A basic shape of the circuit boards may be similar or identical. For example, a rectangular shape with each edge length of the two circuit boards may be the same. For example, the circuit boards and the optionally attached electronic components do not touch. The second circuit board can be protected from excessive heating by spatial separation from the first circuit board. This means that less expensive parts can be used for the second circuit board and/or the measuring unit can be more compact.

In an embodiment, the measuring unit comprises a housing. The housing may form an interior space in which the first circuit board and the second circuit board are arranged. The two circuit boards can be attached to the housing in the interior space. The housing can form closed terminal compartments for the respective connections of the measuring unit. The housing may have a first housing element and a second housing element attached to each other, for example without screws. The housing, for example, can be made of an electrically insulating material such as plastic. The two circuit boards can be stacked on top of each other in the housing. The current converters may not be arranged in the housing and/or comprise a housing separate to the housing of the measuring unit.

The housing may be formed, for example, from injection-molded parts. The housing may have access openings, for example for respective connections and/or data transmission interfaces. The housing may be designed for mounting on a DIN rail. The side facing the DIN rail may define a back side of the housing. The side facing the DIN rail can have a recess for receiving the DIN rail. The power meter can have a clamping device to fix the housing to the DIN rail.

The housing can have a first housing element and a second housing element. The two housing elements can be attached to each other. For example, the two housing elements can be attached to each other without screws. This makes assembly with a robot particularly easy. In addition, there is no risk of a loose screw causing a short circuit. The housing elements may be attached to each other in a detachable or non-detachable manner. For example, the housing elements can be glued or welded together. The housing elements can be attached to each other by means of a snap connection. Alternatively or in addition, the two housing elements can also be attached to each other with screws.

The housing elements may be designed as injection-molded parts. The housing may be free of further housing elements. The first housing element may be designed for attachment to the DIN rail. The first housing element may mainly delimit the interior and/or be designed in the shape of a trough. The second housing element may form a cover of the housing. The first side of the first circuit board can face a wall of the first housing element. For example, the first side of the first circuit board can be arranged adjacent to and parallel to a bottom of the first housing element. The second side of the second circuit board can face a wall of the second housing element. For example, the second side of the second circuit board can be arranged adjacent to and parallel to a top side of the second housing element. The housing can have through openings for respective data interfaces, for example formed on the second housing element.

The first circuit board may be mounted in the housing without screws. Alternatively or additionally, the second circuit board can be mounted in the housing without screws. This can make assembly with a robot particularly easy. For example, the first circuit board and/or the second circuit board can be attached only to the first housing element. However, the second circuit board can also be attached only to the second housing element. The board connector between the two circuit boards can be connected, for example, by attaching the two housing elements to each other or by inserting the two printed circuit boards. The two circuit boards can be clamped only to one of the housing elements or clamped between the two housing elements. The attachment can be realized, for example, by clamping, gluing and/or a snap connection.

For example, the housing can have one or more guides for unambiguous positioning of the first circuit board and/or the second circuit board. These guides can form a snap-in connection between the two housing elements. Such a guide can be a projection, for example extending in the vertical direction, in the first housing element, which engages with a corresponding recess of the respective printed circuit board. The corresponding recess can be formed on a peripheral edge of the respective circuit board. The guide can be a positioning aid that guides the respective printed circuit board when it is inserted into the housing. The guide can also serve as a fastener. For example, the respective printed board can rest on a shoulder in the guide and/or be fixed in a clamping manner by a tapering guide.

Alternatively or in addition, the first and/or second circuit board can be fixed by means of pins. Alternatively or in addition, the first and/or second circuit board can also be fixed to the housing by screw terminals, cage clamps and/or self-tapping screws.

In an embodiment, the packaging comprises a guiding device for guiding a relative movement between the measuring device for determining the sensing error of the current transformer and the packing when both are moved towards each other. The guiding device may be formed by two spaced apart centering cones, which may be provided adjacent to an access opening. The measurement device for determining the sensing error may exhibit one or more complementary structures, e.g. openings, for engaging with the guiding device, e.g. the centering cones, of the packaging. When the measurement device and the packaging are moved toward each other, the guiding device, e.g. the centering cones, may engage with the complementary structure, e.g. the openings, of the measurement device. Further moving the packaging and the measurement device towards each other with the engaged guiding device correctly aligns both components with respect to each other. The correct alignment allows for a determination of the sensing error of the current transformer via the measurement device with high accuracy. Therefore, the guiding device allows for an efficient and accurate determination of the sensing error.

A second aspect relates to a method of providing a system for measuring at least one electrical value in a low-voltage network to a user. The method may be used to provide a system according to the first aspect and/or use the packaging of the second aspect. Further features, embodiments and advantages can be found in the descriptions of the first and second aspect. Conversely, features, embodiments and advantages of the third aspect also represent features, embodiments and advantages of the first and second aspect.

The method may comprise a step of providing a measuring unit. This step may comprise manufacturing and/or assembly of the measuring unit. For example, the first circuit board may be placed into the first housing element. The second circuit board may be placed into the first or second housing element, optionally while connecting the board connector. The first circuit board and/or second circuit board may be fixed to the housing, for example with screws and/or glue. The two housing elements may be attached to each other to close the interior space of the housing.

The method may comprise a step of providing a current transformer. The current transformer may be provided in a packaging and/or with any plugs attached thereto.

The method may comprise a step of determining a sensing error in the current transformer. For this purpose, the current transformer may be attached to a measuring device. The current transformer may remain in its packaging while the sensing error of the current transformer is determined. For example, the current transformer may be connected at least for the purpose of determining its sensing error while remaining in its packaging.

The method may comprise a step of adjusting the measuring unit to able to compensate for a measurement error based on the determined sensing error of the current transformer. For example, a compensation may be programmed in a microcontroller of the measuring unit. The sensing error for multiple current transformer of the system may be determined and the compensation for each individual current transformer sensing error may be adjusted in the measuring unit.

The method may comprise a step of compiling a set of the measuring unit and the current transformers for which the compensation has been adjusted. The measuring unit may be provided in a packaging and the current transformers may each be provided in a packaging. The current transformers may not be attached to each other yet. Instead, the set may be sent out to a user or end-customer. The user or end-customer may connect the current transformers to the measuring unit to assemble a functional system. The user or end-customer may also remove the components from their packagings. The measuring unit may be attached to a power source, such as a power supply. The current transformers may be attached each to an assigned power line of the measuring unit.

### Brief Description of the Drawings

- Fig. 1: schematically illustrates a system for measuring electrical values in three-phase electrical networks.
- Fig. 2: schematically illustrates a split of functions on two circuit boards in a measuring unit of the system according to Fig. 1.
- Fig. 3: schematically illustrates a concept for a galvanic insulation between the two circuit boards.
- Fig. 4: schematically illustrates in an exploded view a housing of the measuring unit.
- Fig. 5: schematically illustrates in a perspective view the two circuit boards of the measuring unit.
- Fig. 6: schematically illustrates in a top view a first embodiment of a current transformer of the system according to Fig. 1 in a packaging, wherein the packaging is in a closed state.
- Fig. 7: schematically illustrates in a top view the current transformer according to Fig. 6 with the packaging in an open state.
- Fig. 8: schematically illustrates in a top view the current transformer according to Fig. 6 taken out of the packaging and the packaging with an inner holder and outer shell disassembled.
- Fig. 9: schematically illustrates in a top view a second embodiment of a current transformer of the system according to Fig. 1 in a packaging and with plugs to connect the current transformer to a measuring device for determining a sensing error.

### Detailed Description of Embodiments

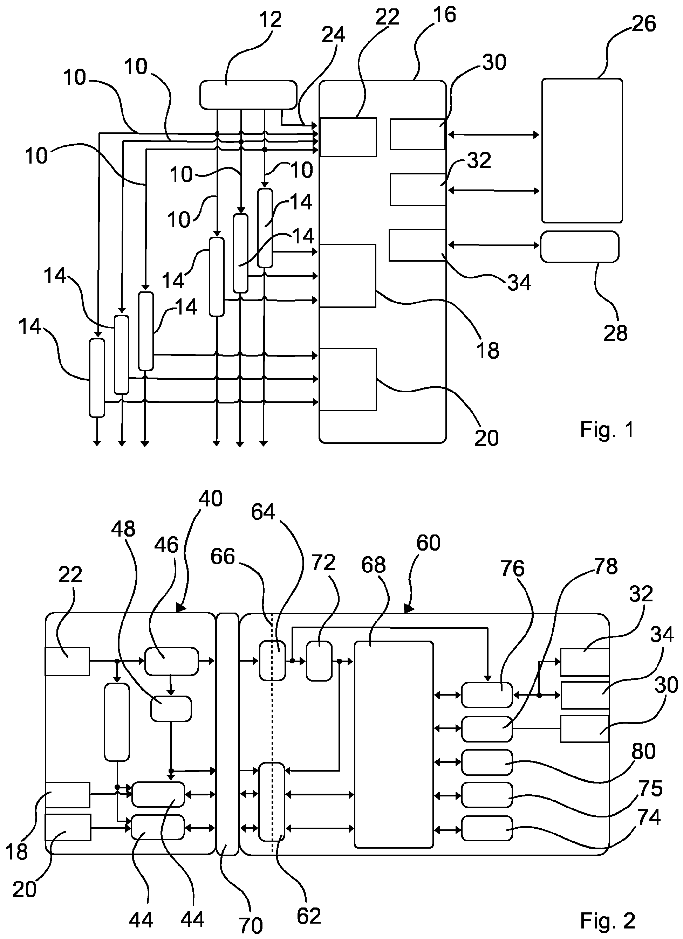

Fig. 1 illustrates a system for measuring electrical values, such as amperage and voltage, in the power lines 10 of a three-phase electrical network 12. The system comprises a current transformer 14 for each power line 10. The system also comprises a measuring unit 16. The current transformers 14 each provide a reduced current proportional to the current in the associated power line 10 to the measuring unit 16. For that purpose, the measuring unit 16 comprises a first set of plugs 18 and a second set of plugs 20. Each set of plugs 18, 20 is configured for the connection of three current transformers 14. In another embodiment, the measuring unit 16 only comprises the first set of plugs 18 and is thus configured for the connection of only three current transformers 14. The measuring unit 16 also comprises a third set of plugs 22 that is configured for connection to the electrical network 12 to power the measuring unit 16. The third set of plugs 22 is also configured for a connection to neutral 24.

The measuring unit 16 is configured to determine the electrical values based on the reduced current provided by the current transformers 14. The measuring unit 16 is configured to provide the determined electrical values to other devices. In the shown example, the measuring unit 16 is providing the determined electrical values to an energy manager 26 and to a server 28. For this purpose, the measuring unit 16 comprises an ethernet data interface 30 that communicates with the energy manager 26. The measuring unit 16 also comprises a Modbus RTU interface 32 which alternatively or additionally communicates with the energy manager 26. The same Modbus RTU interface 32 or a further Modbus RTU interface 34 is communicating with the server 28. The measuring unit 16 may comprise further data interfaces, for example using a Wi-Fi and/or EEBus transmission standard.

Fig. 2 illustrates a split in functionality in the measuring unit 16 on a first circuit board 40 and a second circuit board 60. The first, second and third set of plugs 18, 20, 22 are formed on the first circuit board 40. A voltage divider 42 is formed on the first circuit board 40, which provides power to two internal communication components 44 on the first circuit board 40 configured as a UART (universal asynchronous receiver transmitter). The communication components 44 provide the determined electrical values to the second circuit board 60. A rectifier 46 formed on the first circuit board 40 provides power to the second circuit board 60. Further, a low-dropout-controller 48 is provided on the first circuit board 40. The measuring unit 16 comprises a board connector 70 that connects the first circuit board 40 to the second circuit board 60.

On the second circuit board 60, a galvanic insulator component 62 and a DC-converter 64 is formed, which are configured to galvanically insulate the second circuit board 60 from the first circuit board 40. The galvanic insulation is illustrated by dotted line 66. A data transmission device 68 is formed on the second circuit board 60 which is provided with power with an additional DC-converter 72 formed on the second circuit board 60. The measuring unit 16 can be controlled by a switch 74, for example for a reset, formed on the second circuit board 60. The measuring unit 16 displays a status with a set of LEDs 75 formed on the second circuit board 60. On the second circuit board 60, the two Modbus RTU interfaces 32, 34 are formed and connected to the data transmission device 68 by an electronic component 76. The ethernet data interface 30 is also formed on the second circuit board 60 and connected to the data transmission device 68 by an electronic component 78. A programming connection module 80 is also formed on the second circuit board 60 that allows adjustment of a compensation for a current transformer 14 sensing error in the measuring unit 16, which will be discussed further down below.

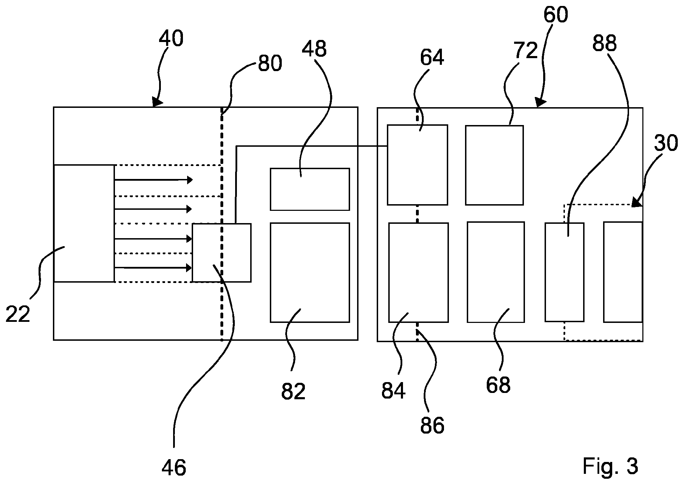

Fig. 3 illustrates a concept for the galvanic insulation between the two circuit boards 40, 60. At the rectifier 46, a functional isolation is established, as indicated by dotted line 81. A base electrical insulation is also provided between the third set of plugs 22 for the power supply and the rectifier 46. A metering-IC 82 for determining the electrical values from the reduced current provided by the current transformers 14 is electrically isolated from the second circuit board 60 by an isolation component 84. The isolation component 84 and the DC-converter 64 provide additional insulation to the other components on the second circuit board 60, such as the additional DC-converter 72 and the date transmission device 68, as indicated by dotted line 86. Fig. 3 further illustrates that the ethernet data interface 30 comprises a transformer 88 for further insulation from and to the ethernet network.

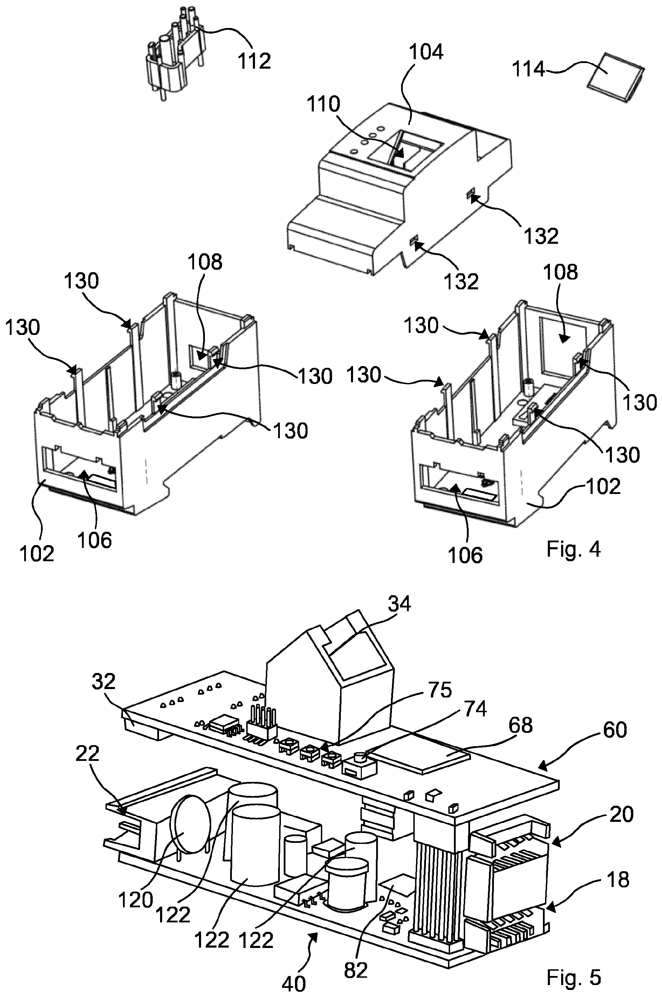

Fig. 4 and Fig. 5 illustrate a design of the components of the measuring unit 16. The measuring unit 16 comprises a housing, which is illustrated in an exploded view with additional components in Fig. 4. Fig. 5 illustrates the two circuit boards 40, 60 as they are arranged within an interior space of the housing.

The housing comprises a first housing element 102 and a second housing element 104. The first housing element 102 has a through shape. On the left side of Fig. 4, a first embodiment of the first housing element 102 is shown that is intended for a configuration of the measuring unit 16 with connections for three current transformers 14. One through hole 106 is provided for the third set of plugs 22 and a second through hole 108 is provided for the first set of plugs 18. The second set of plugs 20 is not present in this configuration. On the right side of Fig. 4, a second embodiment of the first housing element 102 is shown that is intended for a configuration of the measuring unit 16 with connections for six current transformers 14. The second through hole 108 is sized larger in this configuration to accommodate both the first and second set of plugs 18, 20, which are stacked on each other. The second housing element 104 comprises a through hole 110 for the ethernet data interface 30 at its top side. At a backside not visible in Fig. 4, a further through hole is provided for a different data interface, such as Modbus RTU interface 32 and/or the programming connection module 80.

The housing also comprises a light conductor element and a plunger in an integrated component 112. The integrated component 112 allows pushing of the switch 74 from an exterior of the housing. Further, the integrated component 112 conducts light from the set of LEDs 75 through corresponding holes in the second housing element 104 to an exterior. The housing also optionally comprises a cover 114 for any through hole for data interfaces not in use. Fig. 4 illustrates the cover 114 for the through hole 110 for the ethernet data interface 30.

Fig. 5 illustrates details of the two circuit boards 40, 60 and the electrical components formed thereon. Both circuit boards 40, 60 have the same sized rectangular basic shape and are stacked above each other in the housing. The first and second set of plugs 18, 20 for the connection of the current transformers 14 are arranged on one end of the first circuit board 40 and the third set of plugs 22 is arranged on an opposite end thereto. In between, other electrical components, such as a varistor 120, capacitors 122 and the metering-IC 82, are arranged. The board connector 70 is arranged adjacent to the first and second set of plugs 18, 20 on the same end of the first circuit board 40. A plug part of the board connector 70 is formed on the first circuit board 40 and a socket part of the board connector 70 is formed on the second circuit board 60. The Modbus RTU interface 32 and the ethernet data interface 30 are formed on the second circuit board 60. The data transmission device 68 configured as a microprocessor, the switch 74 and the set of LEDs 75 formed on the second circuit board 60 are also visible.

The first housing element 102 and the second housing element 104 are attached to each other with a snap-fit connection. For this purpose, the first housing element 102 comprises protruding cantilever sections 130 that engage corresponding through holes 132 in the second housing element 104. The cantilever sections 130 may also act as guides for the insertion of the circuit boards 40, 60. In the present example, the first circuit board 40 is inserted into the first housing element 102 and attached by screws through the bottom of the first housing element 102. The second circuit board 60 may either be attached to the first housing element 102 or the second housing element 104 with screws. After attachment of the two circuit boards 40, 60, the housing is closed by attaching the two housing elements 102, 104 to each other. The two circuit boards 40, 60 are arranged spaced apart in the housing.

The measuring unit 16 is configured for compensating the sensing error of the current transformers 14. For this purpose, the sensing error of each individual current transformer 14 is determined, for example by measuring with a measuring device dedicated to this purpose. Once determined, the compensation for the sensing error is set in the measuring unit 16 to adjust it to the determined sensing error. For example, a gain and/or a phase shift for the reduced current provided by each current transformer is set.

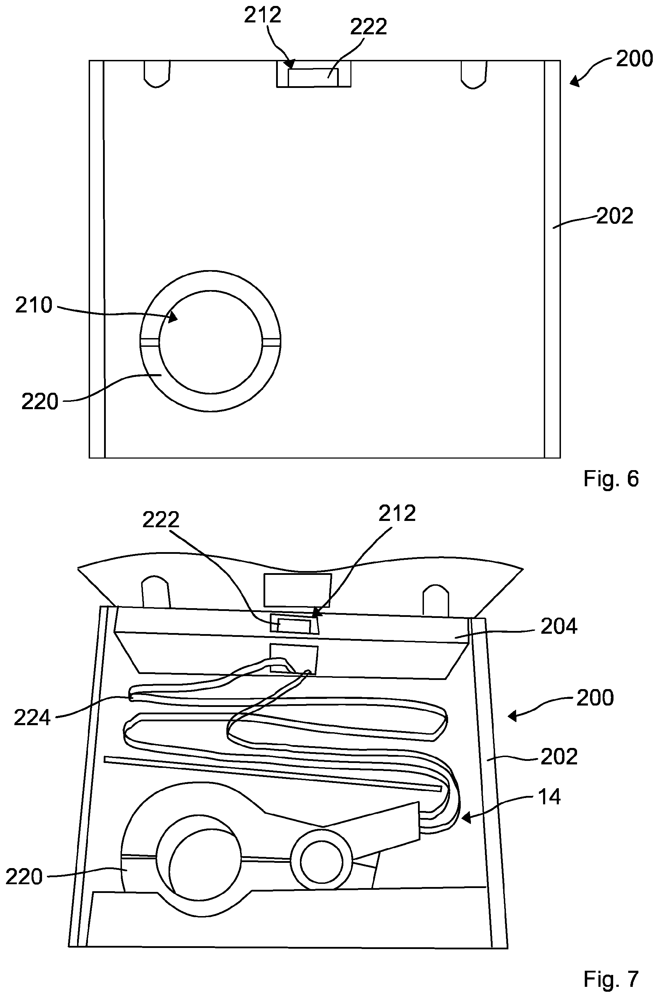

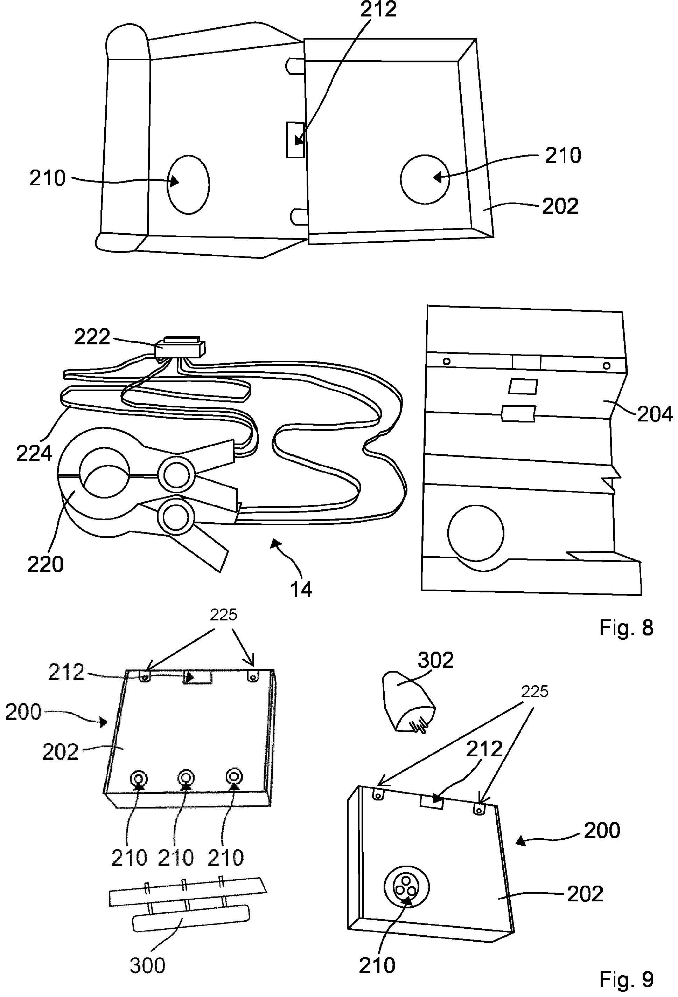

To reduce the effort for the determination of the sensing error, the current transformers 14 are provided in a specific packaging. Fig. 6 illustrates such a packaging 200 for a current transformer 14 configured as a clamp-on current transformer. The packaging 200 comprises an outer shell 202 made from carton. The outer shell 202 can be adjusted between a closed state shown in Fig. 6 and an open state shown in Fig. 7 by opening or closing a lid. The current transformer 14 is held in position in the packaging 200 by an inner holder 204 formed by a folded carton part. The parts of the packaging 200 are also shown in Fig. 8.

As can be seen, the packaging 200 comprises an access opening 210 for connection of a testing power line to the current transformer 14 while the current transformer 14 remains in the packaging 200 with the packaging 200 in the closed state for determining the sensing error. For example, the testing power line can be threaded through the access opening 210. A clamp 220 of the current transformer 14 for connection to the power line 10 is held in a position coaxial to the access opening 210 that is formed as a through hole through the lid and a bottom of the packaging 200.

The packaging 200 also comprises an access opening 212 for connection of the measuring device to the current transformer 14 while the current transformer 14 remains in the packaging 200 with the packaging 200 in the closed state for determining the sensing error. A plug 222 of the current transformer 14 for connection to the measuring device, which is also used for connecting the measuring unit 16, is held in a position coaxial to the access opening 212 that is formed as a through hole through only the lid of the packaging 200.

A cable 224 connects the plug 222 to the clamp 220. The cable 224 is also held in place in a compartment formed in the packaging 200 by the holder 204.

Fig. 9 illustrates an embodiment of a current transformer 14, in which three current transformers are integrated in a common housing and arranged in packaging 200. The packaging 200 again provides access openings 210, 212. The access opening 212 is similar to the first embodiment and provides a connection for the plug 222 to the measuring device and measuring unit 16. The access opening 210 is providing on one side a connection for three different testing power lines at spaced apart locations of three through holes. On an opposite side of the packaging, a common through hole is provided for a common connection of the three testing power lines. Fig. 9 also illustrates a test probe 300 for the connection to the three spaced apart connections and a plug 302 at the common connection. The test probe 300 and the plug 302 can be used for easy and fast connection of the measuring device.

The packaging 200 further comprises a guiding device 225 for guiding a relative movement between the measuring device for determining the sensing error of the current transformer 14 and the packing when both are moved towards each other. In the present embodiment, the guiding device 225 is formed by two spaced apart centering cones, which are provided adjacent the access opening 212. The measurement device (not shown) exhibits complementary openings for engaging with the centering cones 225 of the packaging 200. When the measurement device and the packaging 200 are moved toward each other, the centering cones 225 enter the complementary openings of the measurement device. Further moving the packaging 200 and the measurement device towards each other with the centering cones 225 inside the complementary openings correctly aligns both components with respect to each other. This ensures an effective engagement of the plugs 222, 302 and the test probe 300, respectively. The correct alignment allows for a determination of the sensing error of the current transformer 14 with high accuracy. In one embodiment, the test probe 300 and/or the plug 302 are part of the measurement device.

### Reference Signs

- 10: power line
- 12: electrical network
- 14: current transformer
- 16: measuring unit
- 18: first set of plugs
- 20: second set of plugs
- 22: third set of plugs
- 24: neutral
- 26: energy manager
- 28: server
- 30: data interface
- 32,34: Modbus RTU interface
- 40: first circuit board
- 42: voltage divider
- 44: communication components
- 46: rectifier
- 48: low-dropout-controller
- 60: second circuit board
- 62: galvanic insulator component
- 64: DC-converter
- 66: dotted line
- 68: date transmission device
- 70: board connector
- 72: additional DC-converter
- 74: switch
- 75: LEDs
- 76,78: electronic component
- 80: connection module
- 81: dotted line
- 82: metering-IC
- 84: isolation component
- 86: dotted line
- 88: transformer
- 102: first housing element
- 104: second housing element
- 106, 108, 110: through hole
- 112: integrated component
- 114: cover
- 120: varistor
- 122: capacitors
- 130: cantilever sections
- 132: through holes
- 200: packaging
- 202: outer shell
- 204: inner holder
- 210,212: access opening
- 220: clamp
- 222, 302: plug
- 224: cable
- 225: guiding device
- 300: test probe

## Claims

1. System for measuring at least one electrical value in a low-voltage network, wherein the system comprises at least one current transformer (14) and a packaging (200) in which the current transformer (14) is provided, wherein the packaging (200) is configured to allow access to the current transformer (14) for determining a sensing error while the current transformer (14) remains in the packaging (200).

2. System according to claim 1, wherein the packaging (200) comprises an access opening (210) for connection of a power line (10) to the current transformer (14) in the packaging (200).

3. System according to claim 1 or 2, wherein the packaging (200) comprises an access opening (212) for connection of a measuring device to the current transformer (14) in the packaging (200).

4. System according to one of the preceding claims, wherein the packaging (200) comprises an outer shell (202) and an inner holder (204) for holding the current transformer (14) in place inside of the outer shell (202), preferably for fixing the position of the current transformer (14) relatively to at least one of the access openings (210; 212).

5. System according to one of the preceding claims, wherein the current transformer (14) comprises a plug (222) for connection to a measuring device, the plug (222) preferably being accessible for connection of the measurement device when the current transformer (14) is provided in the closed packaging (200)

6. System according to one of the preceding claims, further comprising a measuring unit (16), wherein the measuring unit (16) is configured for compensating the sensing error of the current transformer (14).

7. System according to claim 6, wherein the measuring unit (16) is configured for an adjustable gain and/or phase shift compensation.

8. System according to any one of the preceding claims, wherein the measuring unit (16) comprises a first circuit board (40), a second circuit board (60), a measuring component (82) and a data transmission device (68), wherein the measuring component (82) is formed on the first circuit board (40), and wherein the data transmission device (68) is formed on the second circuit board (60).

9. System according to claim 8, wherein the first circuit board (40) is arranged spaced apart to the second circuit board (60).

10. System according to claim 8 or 9, wherein the measuring unit (16) comprises a housing (102, 104), wherein the housing (102, 104) forms an interior space in which the first circuit board (40) and the second circuit board (60) are arranged, wherein the housing (102, 104) has a first housing element (102) and a second housing element (104) attached to each other without screws.

11. System according to one of the preceding claims, wherein the packaging (200) comprises a guiding device (225) for guiding a relative movement between a measuring device for determining the sensing error of the current transformer (14) and the packing (200) when both are moved towards each other to ensure proper alignment between the two.

12. Method of providing a system for measuring at least one electrical value in a low-voltage network to a user, the method comprising the following steps:
- providing a measuring unit (16);
- providing a current transformer (14) in a packaging (200) according to one of claims 1 to 11;
- determining a sensing error in the current transformer (14); and
- adjusting the measuring unit (16) to be able to compensate for a measurement error based on the determined sensing error of the current transformer (14).

13. Method of claim 12, wherein the current transformer (14) is provided in a packaging (200) and wherein the sensing error of the current transformer (14) is determined while the current transformer (14) remains in its packaging (200).
